(19) Europäisches Patentamt
European Patent Office
Office européen des brevets

(11) **EP 1 431 769 B1**

(12) **EUROPÄISCHE PATENTSCHRIFT**

(45) Veröffentlichungstag und Bekanntmachung des Hinweises auf die Patenterteilung:
**21.09.2005 Patentblatt 2005/38**

(51) Int Cl.$^7$: **G01R 27/02**

(21) Anmeldenummer: **04006959.3**

(22) Anmeldetag: **10.07.2001**

(54) **Schaltungsanordnung zur Bestimmung des Innenwiderstandes einer linearen Lambdasonde**

Circuit for determining the internal resistance of a linear lambda probe

Ensemble circuit pour déterminer la résistance interne d'une sonde lambda linéaire

(84) Benannte Vertragsstaaten:
**DE ES FR IT SE**

(30) Priorität: **13.07.2000 DE 10034060**
**07.05.2001 DE 10122089**

(43) Veröffentlichungstag der Anmeldung:
**23.06.2004 Patentblatt 2004/26**

(62) Dokumentnummer(n) der früheren Anmeldung(en) nach Art. 76 EPÜ:
**01953909.7 / 1 299 738**

(73) Patentinhaber: **SIEMENS AKTIENGESELLSCHAFT**
**80333 München (DE)**

(72) Erfinder: **Bolz, Stephan**
**93102 Pfatter (DE)**

(56) Entgegenhaltungen:
WO-A-01/96848          DE-A- 3 117 790
DE-A- 3 836 045        DE-A- 3 903 314
DE-A- 19 636 226

**Beschreibung**

Die Erfindung betrifft eine Schaltungsanordnung zur Bestimmung des Innenwiderstandes einer linearen Lambdasonde.

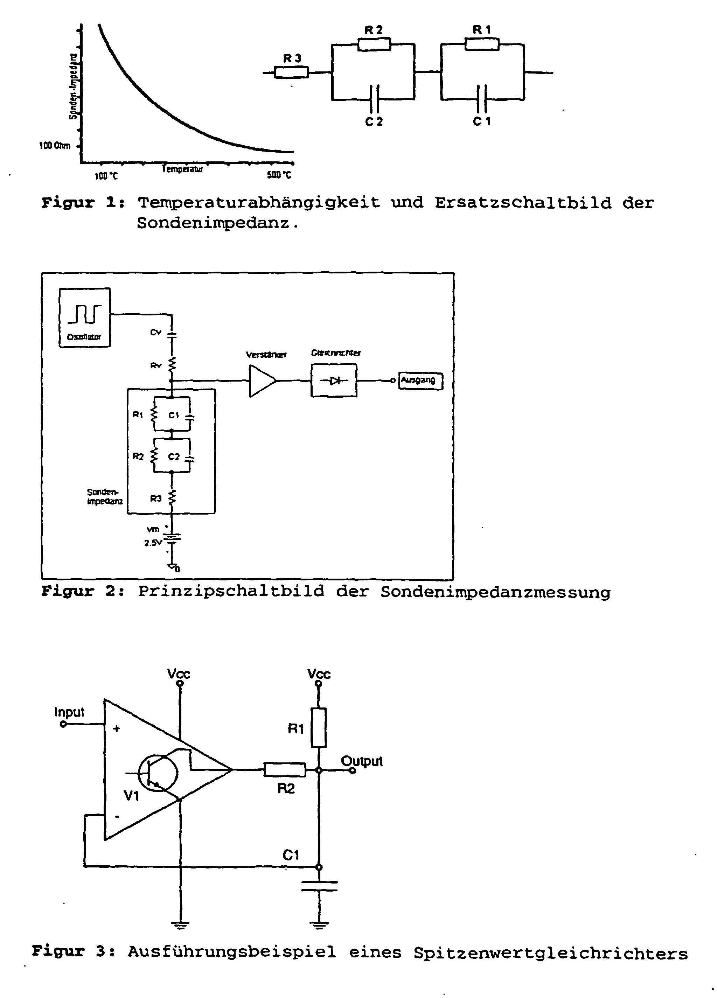

Die Übertragungsfunktion einer linearen Lambdasonde besitzt eine starke Temperaturabhängigkeit, die durch Regelung der Sondentemperatur ausgeglichen weden muß. Aus Kostengründen erfolgt die Messung der Sondentemperatur jedoch nicht über einen separaten Sensor (z.B. Pt100), sondern man nutzt die starke Temperaturabhängigkeit der Sondenimpedanz Ri aus. Figur 1 zeigt die Temperaturabhängigkeit und Ersatzschaltbild der Sondenimpedanz. Dabei repräsentiert

R1/C1 den Übergangswiderstand zwischen Elektroden und Keramikmaterial,
R2/C2 den Übergang zwischen den Korngrenzen der Keramiksinterkörner, und
R3 den Eigenwiderstand des Sintermaterials.

R1 ist stark alterungsabhängig und kann deshalb zur Temperaturmessung nicht heran gezogen werden. Bei geeignter Wahl der Meßfrequenz - beispielsweise 3 kHz - wird R1 durch C1 wechselspannungsmässig kurzgeschlossen; er liefert also keinen Beitrag zur Gesamtimpedanz mehr. Die Reihenschaltung von R2/C2 und R1 ergibt bei dieser Meßfrequenz und ca. 500°C einen Betrag von 100 Ohm und kann zur Temperaturbestimmung herangezogen werden.

In der nicht vorveröffentlichten älteren Patentanmeldung (DE 100 29 795 A1) ist ein gängiges Meßverfahren zur Bestimmung der Sondenimpedanz Ri beschrieben. Danach wird die Sondenimpedanz mit einem rechteckförmigen Wechselstrom, beispielsweise 500μAss (Spitze-Spitze) beaufschlagt. An Ri entsteht eine Wechselspannung von 500μAss * 100Ohm = 50mVss. Diese Wechselspannung wird verstärkt und gleichgerichtet und kann dann einem Mikroprozessor zur Temperaturregelung zugeführt werden.

Die Erzeugung des Wechselstromes erfolgt gemäß Figur 2 beispielsweise mittels eines 3kHz Rechteckoszillators, der mit 5V versorgt wird. Über einen hochohmigen Widerstand Rv und einen Entkoppelkondensator Cv wird das Signal an die Sondenimpedanz geleitet.

Es ist weiter ein magnetischer Positionssensor bekannt (EP 0 478 813 A1), der einen Synchrongleichrichter aufweist. Dieser Synchrongleichrichter ist über ein Tiefpaßfilter mit einem Nullkomperator verbunden.

Es ist Aufgabe der Erfindung, die Messung der Impedanz (des Innenwiderstandes) Ri einer linearen Lambdasonde zu verbessern sowie den Fehler bei der Gleichrichtung des Wechselspannungssignals und die Empfindlichkeit gegen elektromagentische Störimpulse (EMV)zu reduzieren. Allgemein ist es Aufgabe der Erfindung, den Spitze-Spitze-Amplitudenwert (Vss) eines Wechselspannungssignals, dessen Phase bekannt ist und dem eine Gleichspannung überlagert ist, präzise zu erfassen.

Bei der bekannten Schaltung wird ein in Figur 3 dargestellter Spitzenwertgleichrichter zur Wandlung des Wechselspannungssignals in eine Gleichspannung verwendet. Dieser arbeitet folgendermaßen: am Eingang (Input) liege eine Gleichspannung von 2.5V (Mittenspannung Vm) an. Der Komparator V1 arbeitet als Spannungsfolger; also beträgt die Spannung am Ausgang (Output) ebenfalls 2.5V. Dies wird erreicht, indem sich C1 über R1 langsam auflädt. Solange die Spannung am Ausgang kleiner als die Eingangsspannung ist, bleibt der Ausganstransistor des Komparators V1 ausgeschaltet. Übersteigt die Ausgangsspannung die Eingangsspannung, so schaltet der Transistor ein und entlädt C1 über R2, bis die Ausgangsspannung wieder unter der Eingansspannung liegt. Dann schaltet der Transisor wieder aus und die Ausgangsspannung steigt, getrieben durch den Ladestrom von R1, langsam wieder an.
Es entsteht eine Pendelschwingung um Vout = Vin. Wichtig ist dabei, daß die Zeitkonstanten zum Laden und Entladen des Kondensators stark unterschiedlich sind:

$$\tau_{lade} = R1*C1, \; \tau_{entlade} = R2 * C1$$

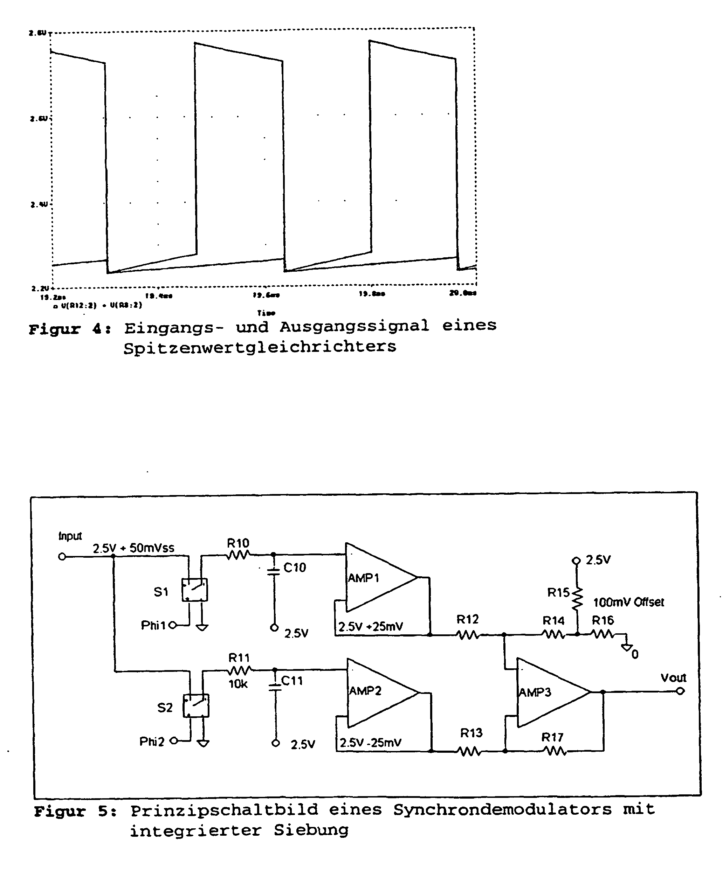

In einer realen Schaltung wählt man das Verhältnis $\tau_{lade}/\tau_{entlade}$ etwa 100/1, was einen Meßfehler von 1% ergibt. Legt man an den Eingang beispielsweise ein Rechtecksignal mit 500mVss Amplitude an, welches mit einer Gleichspannung von Vm (2.5V) überlagert ist, so wird des Ausgang sehr schnell dem unteren Spitzenwert des Eingangssignals folgen (negative Halbwelle) und beim oberen Spitzenwert nur langsam wieder ansteigen. In der Wirkungsweise entsteht so am Ausgang eine Gleichspannung, die dem unteren Spitzenwert der Eingangs-(Wechsel- + Gleich-)spannung entspricht, siehe Figur 4.

Der Gleichrichter wandelt das Wechselspannungssignal (500mVss) - obere Kurve in Figur 4 - in ein Gleispannungssignal (-250mV) um - untere Kurve. Der Nullpunkt liegt bei Vm = +2.5V. Das Ausgangssigal beträgt also im Mittel

+2.50V - 0.25V = +2.25V.

Zur Verdeutlichung der Funktionsweise wurde die Filterzeitkonstante stark reduziert. Das Ausgangssignal zeigt deshalb eine verstärkte Welligkeit im Vergleich zur typischen Anwendung. Damit ergibt sich ein einfacher, kostengünstiger Aufbau mit Standardkomponenten, der die ursprünglichen Genauigkeitsanforderungen erfüllt.

Diese Schaltung produziert jedoch eine Verfälschung des Ausgangswertes bei Dachschräge des Rechtecksignals (z.B. wegen zu kleiner Koppelkondensatoren oder Rückwirkungen aus der Sondenregelschleife) und hat eine starke Empfindlichkeit gegenüber EMV-Störimpulsen, bedingt durch das rasche Ansprechen des Gleichrichters.

Erfindungsgemäß wird der Spitzenwertgleichrichter durch einen Synchrondemodulator mit integrierter Siebung ersetzt. Da Phase und Frequenz des Meßsignals bekannt sind, ist es möglich, eine vom Oszillatorsignal gesteuerte Gleichrichtung vorzunehmen.

Figur 5 zeigt die Schaltung eines erfindungsgemäßen Synchrondemodulators mit integrierter Siebung.

Der Eingang der Schaltung (Input) ist mit dem Ausgang des in Figur 2 gezeigten Verstärkers verbunden. Die Eingänge der Schalter S1, S2 sind mit dem Eingang der Schalter verbunden. Der Ausgang von S1 ist mit einem Anschluß des Kondensators C10 und dem nichtinvertierenden Eingang des Verstärkers AMP1 verbunden. Der andere Anschluß von C10 ist mit der in Figur 2 gezeigten Gleichspannungs-quelle Vm (2.5V) verbunden. Der invertiernde Eingang von AMP1 ist mit dessen Ausgang verbunden.

Der Ausgang von S2 ist mit einem Anschluß des Kondensators C11 und dem nichtinvertierenden Eingang des Verstärkers AMP2 verbunden. Der andere Anschluß von C11 ist mit Vm verbunden. Der invertiernde Eingang von AMP2 ist mit dessen Ausgang verbunden.

Der Widerstand R12 ist einerseits mit dem Ausgang von AMP1 verbunden, andererseits mit dem nichtinver-tierenden Eingang von AMP3 und R14. Der andere Anschluß von R14 ist mit R15 und R16 verbunden. Der andere Anschluß von R15 ist mit 2.5V verbunden, der von R16 mit Masse. R13 ist einerseits mit dem Ausgang von AMP2 verbunden, andererseits mit dem invertierenden Eingang von AMP3 und R17. R17 führt weiter zum Ausgang von AMP3, wo sich auch der Ausgang (Output) der Schaltung befindet.

S1, R10 und C10 stellen eine Sample and Hold (Abtast- und Halte-) Schaltung dar, ebenso S2, R11, undC11.

Phi1 ist das Steuersignal des Schalters S1, es entspricht beispielsweise dem Signal des in Figur 2 gezeigten Oszillators. S1 ist geschlossen, solange das Oszillatorsignal 5V beträgt, und geöffnet, wenn das Oszillatorsignal 0V beträgt.

Auf diese Weise ist der Kondensator C10 wärend der positiven Phase des Oszillatorsignals über R10 mit dem Input verbunden. Er wird sich folglich langsam - entsprechend der Zeitkonstante $\tau$ = R10*C10 auf den positiven Wert des Eingangssignales aufladen. Durch die Synchronisierung von Schalterbetätigung und Eingangssignal erfolgt eine Mittelung auf den positivem Signalwert. C10 ist nicht mit Masse, sonden mit Vm = 2.5V verbunden. Dadurch verringert sich die am Kondensator C10 anliegende Gleichspannung, was den Leckstrom des Kondensators verringert.

Der nachfolgende Verstärker AMP1 hat Verstärkung 1 und dient der hochohmigen Entkopplung von C10, um eine Entladung in der Haltephase (S1 offen) zu vermeiden. Am Ausgang von AMP1 entsteht eine Gleichspannung, die der Gleichspannung Vm = +2.5V und dem positiven Scheitelwert des Eingangssignals entspricht. Vout (AMP1) = 0,025V + 2.5V = +2.525V.

Die zweite Sample&Hold-Schaltung (S2, R11, C11) dient der Messung des negativen Signalwertes. Das Steuersignal Phi2 ist deshalb zu S1 invertiert. Das übrige Verhalten entspricht ansonsten der ersten Sample&Hold-Schaltung, wobei am Ausgang von AMP2 nun die Spannung -0,025V + 2.5V = +2.475V entsteht.

Der Verstärker AMP3 bildet zusammen mit den Widerständen R12, R13, R14, R15, R16, R17) einen Differenzverstärker. R12 und R13 haben den gleichen Widerstandswert. Der Widerstand der Reihenschaltung von R14 mit der Parallelschaltung von R15 und R16 entspricht dabei dem von R17. Die Verstärkung ist über das Verhältnis von R17 und R13 bestimmt (Vu = R17/R13).

Über R15 wird dem Differenzverstärker AMP3 eine weitere Spannung (+2.5V) zugeführt. Bei entsprechender Wahl von R14, R15 und R16 kann damit eine bestimmte Ausgangsspannung bei fehlender Eingangsspannung festgelegt werden. Dieser Offset ist ebenso wie die Gleichspannung Vm = +2.5V für Systeme mit fehlender negativer Versorgungsspannung erforderlich, da der Ausgang des Verstärkers AMP3 dann 0V nicht erreichen kann. Vm und der Offset ermöglichen erst den Betrieb der Schaltung in einem 0/5V Netz.

Der so entstandene Differenzverstärker wandelt nun die Differenz der Ausgangsspannungen von AMP1 und Amp2 in ein Ausgangssignal um, wobei die den Eingangssignalen gemeinsame Gleichspannung (2.5V) unterdrückt wird und die DIfferenz um den Wert der Verstärkung Vu verstärkt wird.

Am Ausgang von AMP3 entsteht ein um Vu verstärktes, gleichgerichtetes Abbild des Eingangssignals, welches noch um den Offset verschoben ist. Diese Spannung kann nun beispielsweise dem A/D-Konverter eines Microcontrollers zur weiteren digitalen Verarbeitung zugeführt werden.

Um die Genauigkeit des Synchrongleichrichters weiter zu steigern, kann man, abhängig von der Kurvenform des Eingangssignals, die Einschaltzeiten von S1 und S2 verändern.

Besitzt das Eingangssignal beispielsweise eine exponentielle Dachschräge, so ist es sinnvoll, nur den hinteren Teil der positiven bzw negativen Amplitude zu messen. Dazu ist eine weitere Schaltung erforderlich, die aus dem Oszillatorsignal weitere Signale mit veränderter Phasenlage und Pulsbreite erzeugt (modifizierte Phi1 und Phi2). Phi1 sei dabei nicht mehr von 0% bis 50% des Oszillatorsignals auf 5V, sondern nur noch von 25% bis 50%. Phi2 sei dabei nicht mehr von 50% bis 100%, sondern nur noch von 75% bis 100%.

Entsprechend wird vom Eingangssignal nur noch der Bereich von 25% bis 50% des positiven Amplitudenwertes in der ersten Sample&Hold-Schaltung abgetastet und der Bereich von 75% bis 100% des negativen Amplitudenwertes.

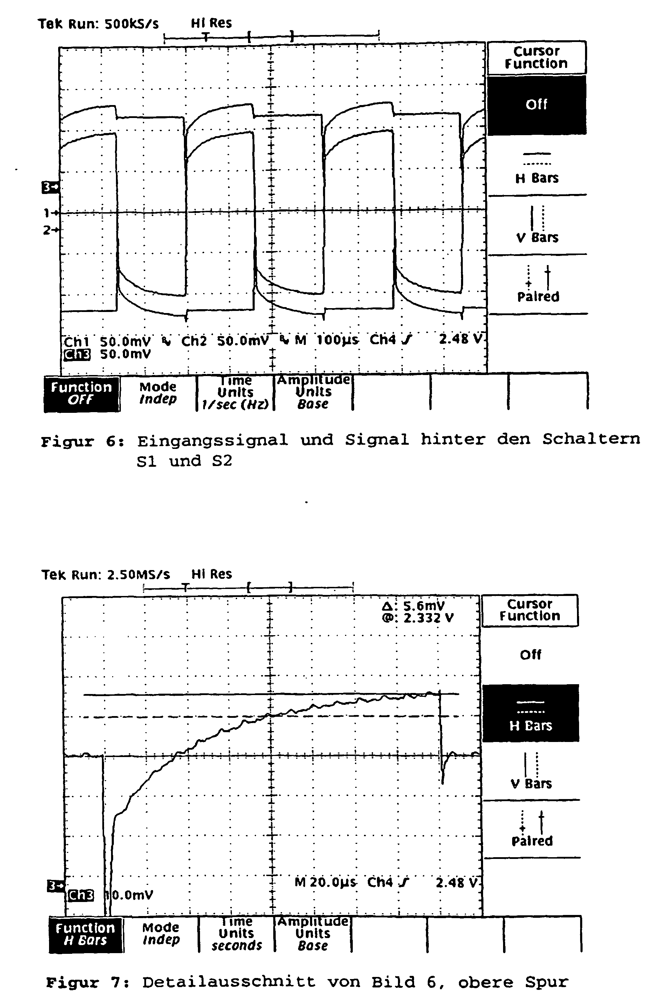

Figur 6 zeigt das Eingangssignal und das Signal hinter den Schaltern S1 und S2.

Die obere Spur (zur besseren Sichtbarkeit nach oben verschoben) zeigt das Signal am Ausgang von S1. Solange S1 geschlossen ist, folgt es dem Kurvenverlauf des Eingangssignals (e-Funktion), bei geöffnetem S1 wird die Spannung an C10 sichtbar (gerader Strich).

Die mittlere Spur stellt ein - reales - Eingangssignal dar, wie es durch den komplexen Innenwiderstand der linearen Lambdasonde gebildet wird.

Die untere Spur (zur besseren Sichtbarkeit nach unten verschoben) zeigt das Signal am Ausgang von S2.

Figur 7 zeigt einen Detailausschnitt der oberen Spur von Figur 6:

> durchgezogene Linie: Spitzenwert des Signals,
> vertikale Bildmitte: Spannung an C10,
> horizontale Bildmitte: 25%-Punkt des Signals,
> gestrichelte Linie : Neues Mittelungsintervall.

Der Meßfehler des Synchrondemodulators beträgt 14mV bzw. 7%, bezogen auf die hier verwendete Signalamplitude von 200mVss. Grund dafür ist die recht grosse Schwankung des positiven Amplitudenwertes, über die gemittelt wird (Exponentialfunktion).

Bei Verwendung eines Samplingintervalles von 25% bis 50% reduziert sich diese Schwankung auf ca 7mV (Differenz zwischen durchgezogener und gestrichelter Linie in Figur 7), so daß sich nach der Mittelung ein Restfehler von <3mV ergibt, was 1.5% entspricht.

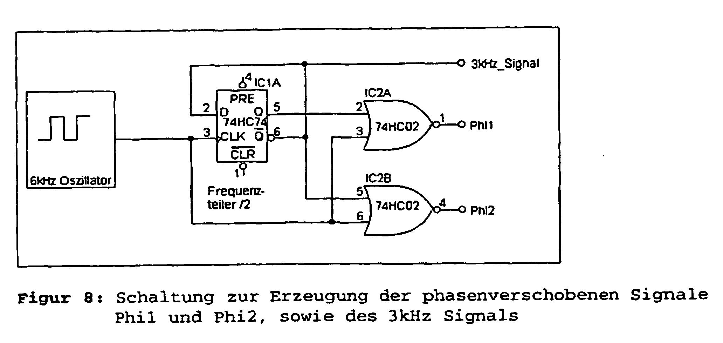

Figur 8 zeigt eine Schaltung zur Erzeugung der phasenverschobenen Signale Phi1 und Phi2, sowie des 3kHz Signals.

Der Ausgang des Oszillators ist mit dem Takteingang CLK des Flip-Flop IC1a und mit dem Eingang 3 des NOR-Gatters IC2A und dem Eingang 6 des NOR Gatters IC2B verbunden. Der Ausgang Q des Flip-Flip IC1a ist mit dem Eingang 2 des Gatters IC2A verbunden. Der Ausgang Q quer des Flip-Flip IC1a ist mit seinem Dateneingang D und dem Eingang 5 des Gatters IC2b verbunden.;er stellt das 3kHz-Signal dar. Der Ausgang des Gatters IC2A stellt das Signal Phi1 dar, der Ausgang des Gatters IC2B stellt das Signal Phi2 dar.

Das Flip-Flop IC1A arbeitet wegen der Rückführung des Ausgangs Q quer auf den Dateneingang als Frequenzteiler (:2). Am Ausgang Qquer entsteht entsprechend das 3kHz-Signal, das über Rv und Cv (Figur 2) auf die Sondenimpedanz geleitet wird. IC1 schaltet mit der ansteigenden Flanke des 6kHz Oszillators. Das Oszillatorsignal gelangt zusammen mit dem Ausgangssignal Q quer (von IC1A)auf die Eingänge des Gatters IC2B. Sind beide Eingangssignale 0V, so ist sein Ausgangssignal 5V. Bezogen aus das 3kHz-Signal ist dies von 75% bis 100% der Taktphase der Fall, wie oben für Phi2 gefordert.

Das Oszillatorsignal gelangt auch zusammen mit dem Ausgangssignal Q (von IC1A) auf die Eingänge des Gatters IC2A. Sind beide Eingangssignale 0V, so ist sein Ausgangssignal 5V. Bezogen auf das 3kHz-Signal ist dies von 25% bis 50% der Taktphase der Fall, wie oben für Phi1 gefordert.

**Patentansprüche**

1. Vorrichtung zum Messen der Sondenimpedanz (R1, C1, R2, C2, R3) einer linearen Lambdasonde einer Brennkraftmaschine, mit einem Spannungsverstärker (Verstärker) zur Verstärkung einer an der Sondenimpedanz (R1, C1, R2, C2, R3) abfallenden Wechselspannung, die durch ein in die Lambdasonde eingespeistes Wechselstrom-Meßsignal hervorgerufen wird, und mit einem Gleichrichter (Gleichrichter) zur Gleichrichtung der verstärkten Wechselspannung (Input),
   **dadurch gekennzeichnet,**
   **daß** der Gleichrichter ein Synchrondemodulator ist, von welchem jeweils die obere und untere Amplitude des Wechselspannungssignals (Input) mit dessen Frequenz abgetastet (S1, S2), gefiltert (R10, C10; R11, C11) und gespeichert wird und von welchem die Differenz der gespeicherten Signale, mit einem Verstärkungsfaktor verstärkt (AMP3), als Ausgangssignal (Vout) an seinem Ausgang (Ausgang) zur Temperaturregelung der Lambdasonde bereitgestellt wird.

2. Vorrichtung nach Anspruch 1, **dadurch gekennzeichnet, daß** ein Oszillator vorgesehen ist, aus dessen Ausgangssignal sowohl das Wechselstrom-Meßsignal als auch die Steuersignale (Phi1, Phi2) für den Synchrondemodulatorgewonnen werden.

3. Vorrichtung nach Anspruch 1, **dadurch gekennzeichnet, daß** der Synchrondemodulator

   - eine erste Abtast- und Halteschaltung (S1-R10-C10) aufweist, in welcher die obere Amplitude des Eingangssignals (Input) abgetastet und gehalten wird, und
   - eine zweite Abtast- und Halteschaltung (S2-R11-C11) aufweist, in welcher die untere Amplitude des Eingangssignals (Input) abgetastet und gehalten wird,

   einen jeder Abtast- und Halteschaltung nachgeschalteten Entkopplungsverstärker (AMP1, AMP2) aufweist, und

- einen Differenzverstärker (AMP3) aufweist, der ein Differenzsignal aus den Ausgangssignalen der beiden Entkopplungsverstärker (AMP1, AMP2) bildet und als Ausgangssignal (Vout) am Ausgang des Synchrondemodulators als Regelsignal für die Temperaturregelung der Lambdasonde bereitstellt.

4. Vorrichtung nach Anspruch 3, **dadurch gekennzeichnet, daß** der Widerstand und der Kondensator (R10-C10, R11-C11) jeder Abtast- und Halteschaltung in der Abtastphase ein Tiefpaßfilter zur integrierten Signalmittelung des Eingangssignals (Input) bilden, und
daß die Kondensatoren (C10, C11) in der Haltephase als Haltekondensatoren wirken.

5. Vorrichtung nach Anspruch 3, **dadurch gekennzeichnet, daß** jeder der beiden Kondensatoren (C10, C11) an ein vorgegebenes Potential gelegt ist.

6. Vorrichtung nach Anspruch 3, **dadurch gekennzeichnet, daß** beide Entkopplungsverstärker einen vorgegebenen Verstärkungsfaktor aufweisen.

7. Vorrichtung nach Anspruch 3, **dadurch gekennzeichnet, daß** zwischen dem Ausgang jedes der beiden Entkopplungsverstärker (AMP1, AMP2) und dem zugeordneten Eingang des Differenzverstärkers (AMP3) ein Widerstand (R12, R13) angeordnet ist und beide Widerstände den gleichen Widerstandswert aufweisen.

8. Vorrichtung nach Anspruch 3, **dadurch gekennzeichnet, daß** von dem nichtinvertierenden Eingang des Differenzverstärkers (AMP3) ein Spannungsteiler (R14, R16) zu einem Bezugspotential (0V) führt, und daß ein Widerstand (R15) zwischen dem Abgriff des Spannungsteilers (R14, R16) einem vorgegebenen Potential angeordnet ist.

9. Vorrichtung nach Anspruch 8, **dadurch gekennzeichnet, daß** der Widerstandswert der Reihenschaltung der Widerstände (R14, R15, R16) gleich dem eines zwischen Ausgang und invertierendem Eingang des Differenzverstärkers angeordneten Widerstand (R17).

10. Vorrichtung nach Anspruch 1, **dadurch gekennzeichnet, daß** der Synchrondemodulator (GLR) durch Ansteuerung der Schalter (S1, S2) mit Steuersignalen jeweils nur einen Teil kleiner als 50% der Periode des Wechselspannungssignals (Vein) mit dessen Frequenz abtastet.

## Claims

1. Device for measuring the probe impedance (R1, C1, R2, C2, R3) of a linear lambda probe of an internal combustion engine, having a voltage amplifier (Amplifier) for amplifying an alternating voltage which drops across the probe impedance (R1, C1, R2, C2, R3) and which is caused by an alternating current measuring signal which is fed into the lambda probe, and having a rectifier (Rectifier) for rectifying the amplified alternating voltage (Input), **characterized in that** the rectifier is a synchronous demodulator which samples (S1, S2) the respective upper and lower amplitudes of the alternating voltage signal (Input) with its frequency, filters them (R10, C10; R11, C11) and stores them, and which makes available the difference in the stored signals, after having amplified (AMP3) them with a gain factor, as an output signal (Vout) at its output (Output) for regulating the temperature of the lambda probe.

2. Device according to Claim 1, **characterized in that** an oscillator is provided from whose output signal both the alternating current measuring signal and the control signals (Phi1, Phi2) for the synchronous demodulator are required.

3. Device according to Claim 1, **characterized in that** the synchronous demodulator

- has a first sample-and-hold circuit (S1-R10-C10) in which the upper amplitude of the input signal (Input) is sampled and held, and
- has a second sample-and-hold circuit (S2-R11-C11) in which the lower amplitude of the input signal (Input) is sampled and held,

has a decoupling amplifier (AMP1, AMP2) which is connected downstream of each sample-and-hold circuit, and

- has a difference amplifier (AMP3) which forms a difference signal from the output signals of the two decoupling amplifiers (AMP1, AMP2) and makes it available as an output signal (Vout) at the output of the synchronous demodulator as a regulating signal for regulating the temperature of the lambda probe.

4. Device according to Claim 3, **characterized in that** the resistor and the capacitor (R10-C10, R11-C11) of each sample-and-hold circuit form, in the sampling phase, a low-pass filter for integrated signal averaging of the input signal (Input), and **in that** the capacitors (C10, C11) act as holding capacitors in the hold phase.

5. Device according to Claim 3, **characterized in that** each of the two capacitors (C10, C11) is connected to a predefined potential.

6. Device according to Claim 3, **characterized in that** the two decoupling amplifiers have a predefined gain factor.

7. Device according to Claim 3, **characterized in that** a resistor (R12, R13) is arranged between the output of each of the two decoupling amplifiers (AMP1, AMP2) and the assigned input of the difference amplifier (AMP3), and both resistors have the same resistance value.

8. Device according to Claim 3, **characterized in that** a voltage divider (R14, R16) is connected to a reference potential (0V) by the non-inverting input of the difference amplifier (AMP3), and **in that** a resistor (R15) is arranged between the tap of the voltage divider (R14, R16) and a predefined potential.

9. Device according to Claim 8, **characterized in that** the resistance value of the series circuit of the resistors (R14, R15, R16) is equal to that of a resistor (R17) which is arranged between the output and the inverting input of the difference amplifier.

10. Device according to Claim 1, **characterized in that** by actuating the switches (S1, S2) with control signals the synchronous demodulator (GLR) samples in each case only a part, which is less than 50%, of the period of the alternating voltage signal (Vein) with its frequency.

**Revendications**

1. Dispositif pour mesurer l'impédance (R1, C1, R2, C2, R3) d'une sonde lambda linéaire d'un moteur à combustion interne, comportant un amplificateur de tension (amplificateur) destiné à amplifier une tension alternative décroissante sur l'impédance de la sonde (R1, C1, R2, C2, R3), laquelle est due à un signal de mesure à courant alternatif introduit dans la sonde lambda, et comportant un redresseur (redresseur) destiné à redresser la tension alternative amplifiée (Input), **caractérisé en ce que** le redresseur est un démodulateur synchrone, dont respectivement l'amplitude supérieure et inférieure du signal de tension alternative (Input) est analysée avec la fréquence de celui-ci (S1, S2), filtrée (R10, C10 ; R11, C11) et stockée, et dont la différence entre les signaux stockés est amplifiée (AMP3) avec un facteur d'amplification, et est délivrée comme signal de sortie (Vout) à sa sortie (sortie) en vue du réglage de la température de la sonde lambda.

2. Dispositif selon la revendication 1, **caractérisé en ce qu'**il est prévu un oscillateur, dont le signal de sortie permet d'obtenir le signal de mesure de courant alternatif, de même que des signaux de commande (Phi1, Phi2) pour le démodulateur synchrone.

3. Dispositif selon la revendication 1, **caractérisé en ce que** le démodulateur synchrone comporte :

   - un premier circuit de balayage et de maintien (S1-R10-C10), dans lequel l'amplitude supérieure du signal d'entrée (Input) est balayée et maintenue, et
   - un deuxième circuit de balayage et de maintien (S2-R11-C11), dans lequel l'amplitude inférieure du signal d'entrée (Input) est balayée et maintenue,
   - un amplificateur de découplage (AMP1, AMP2) monté en aval de chaque circuit de balayage et de maintien, et
   - un amplificateur différenciateur (AMP3), qui forme un signal de différence à partir des signaux de sortie des deux amplificateurs de découplage (AMP1, AMP2) et le délivre sous forme de signal de sortie (Vout) à la sortie du démodulateur synchrone en tant que signal de réglage pour le réglage de la température de la sonde lambda.

4. Dispositif selon la revendication 3, **caractérisé en ce que** la résistance et le condensateur (R10-C10, R11-C11) de chaque circuit de balayage et de maintien forment dans la phase de balayage un filtre passe-bas pour le calcul de la moyenne intégrée du signal d'entrée (Input) et **en ce que** les condensateurs (C10, C11) agissent dans la phase de maintien comme des condensateurs de maintien.

5. Dispositif selon la revendication 3, **caractérisé en ce que** chacun des deux condensateurs (C10, C11) est appliqué à un potentiel prédéfini.

6. Dispositif selon la revendication 3, **caractérisé en ce que** les deux amplificateurs de découplage comportent un facteur d'amplificateur prédéfini.

7. Dispositif selon la revendication 3, **caractérisé en ce qu'**une résistance (R12, R13) est agencée entre la sortie de chacun des deux amplificateurs de découplage (AMP1, AMP2) et l'entrée associée de l'amplificateur différenciateur (AMP3), et les deux résistances ont la même valeur de résistance.

8. Dispositif selon la revendication 3, **caractérisé en ce que**, à partir de l'entrée non inversée de l'amplificateur différenciateur (AMP3), un diviseur de tension (R14, R16) guide vers un potentiel de référence (0 V), et **en ce qu'**une résistance (R15) est agencée entre le branchement du diviseur de tension (R14, R16) et un potentiel prédéfini.

9. Dispositif selon la revendication 8, **caractérisé en ce que** la valeur de résistance du montage en série des résistances (R14, R15, R16) est égale à la résistance (R17) agencée entre la sortie et l'entrée inversée de l'amplificateur différenciateur.

10. Dispositif selon la revendication 1, **caractérisé en ce que**, par l'activation des commutateurs (S1, S2) avec des signaux de commande, le démodulateur synchrone (GLR) balaye avec la fréquence du signal de tension alternative dans chaque cas seulement une partie, inférieure à 50 % de la période du signal de tension alternative (Vein).

**Figur 1:** Temperaturabhängigkeit und Ersatzschaltbild der Sondenimpedanz.

**Figur 2:** Prinzipschaltbild der Sondenimpedanzmessung

**Figur 3:** Ausführungsbeispiel eines Spitzenwertgleichrichters

**Figur 4:** Eingangs- und Ausgangssignal eines
Spitzenwertgleichrichters

**Figur 5:** Prinzipschaltbild eines Synchrondemodulators mit
integrierter Siebung

Figur 6: Eingangssignal und Signal hinter den Schaltern
S1 und S2

Figur 7: Detailausschnitt von Bild 6, obere Spur

**Figur 8:** Schaltung zur Erzeugung der phasenverschobenen Signale Phi1 und Phi2, sowie des 3kHz Signals